(19) Europäisches Patentamt / European Patent Office / Office européen des brevets

(11) **EP 3 107 127 B1**

(12) **EUROPEAN PATENT SPECIFICATION**

(45) Date of publication and mention
of the grant of the patent:
**30.03.2022 Bulletin 2022/13**

(21) Application number: **15172216.2**

(22) Date of filing: **15.06.2015**

(51) International Patent Classification (IPC):
*H01L 31/108* (2006.01)   *H01L 31/028* (2006.01)
*H01L 31/0352* (2006.01)   *H01L 27/146* (2006.01)

(52) Cooperative Patent Classification (CPC):
**H01L 31/028; H01L 27/14601; H01L 27/14643;**
**H01L 31/035209; H01L 31/035218; H01L 31/108**

(54) **DEVICE FOR SENSING RADIATION**

BAUELEMENT ZUR DETEKTION VON STRAHLUNG

DISPOSITIF POUR LA DÉTECTION DE RAYONNEMENT

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(43) Date of publication of application:
**21.12.2016 Bulletin 2016/51**

(73) Proprietor: **Nokia Technologies Oy**
**02610 Espoo (FI)**

(72) Inventors:
• **White, Richard**
**Huntingdon, PE28 9DY (GB)**
• **Allen, Mark**
**Cambridge, Cambridgeshire CB23 6BA (GB)**

(74) Representative: **Swindell & Pearson Limited**
**48 Friar Gate**
**Derby DE1 1GY (GB)**

(56) References cited:
**CN-A- 104 538 489**

• **RIAZIMEHR SARAH ET AL: "Spectral sensitivity of a graphene/silicon pn-junction photodetector", EUROSOI-ULIS 2015: 2015 JOINT INTERNATIONAL EUROSOI WORKSHOP AND INTERNATIONAL CONFERENCE ON ULTIMATE INTEGRATION ON SILICON, IEEE, 26 January 2015 (2015-01-26), pages 77-80, XP032748024, DOI: 10.1109/ULIS.2015.7063777 [retrieved on 2015-03-18]**
• **ALEXANDER V KLEKACHEV ET AL: "Graphene Transistors and Photodetectors", INTERFACE, vol. 22, no. 1, 1 January 2013 (2013-01-01), pages 63-68, XP055237499, US ISSN: 1064-8208**
• **Miao Zhu ET AL: "TiO 2 enhanced ultraviolet detection based on a graphene/Si Schottky diode", Journal of Materials Chemistry A, vol. 3, no. 15, 1 January 2015 (2015-01-01), pages 8133-8138, XP055723299, GB ISSN: 2050-7488, DOI: 10.1039/C5TA00702J**

**Description**

TECHNOLOGICAL FIELD

Examples of the present disclosure relate to an apparatus for sensing. Some examples, though without prejudice to the foregoing, relate to an apparatus for photo detection.

BACKGROUND

Photodetectors are known. Typical photodetector devices enable incident light to be transduced to electrical charge which can then be measured. Conventional photodetector devices are not always optimal. It is useful to enable photodetector devices to operate efficiently.

Miao Zhu et al., "TiO2 enhanced ultraviolet detection based on a graphene/Si Schottky diode" Journal of Materials Chemistry A, vol. 3 Issue 15, January 2015 pages 8133-8138 discloses enhanced ultraviolet detection based on a graphene/Si Schottky diode using $TiO_2$. This disclosure mentions that Graphene/Si has been proved to form a quality Schottky junction with high photoelectric conversion efficiency at AM 1.5. However, for the ultraviolet portion of the incident light, the photoelectric performance will degrade significantly due to severe absorption and recombination at the front surface. In order to realize enhanced ultraviolet detection with a graphene/Si diode, $TiO_2$ nanoparticles (NPs, 3-5 nm) are synthesized and spin-coated on the graphene surface to improve the photoresponse in the ultraviolet region.

The listing or discussion of any prior-published document or any background in this specification should not necessarily be taken as an acknowledgement that the document or background is part of the state of the art or is common general knowledge. One or more aspects/examples of the present disclosure may or may not address one or more of the background issues.

BRIEF SUMMARY

The scope of protection sought for various embodiments of the invention is set out by the independent claims.

According to the disclosure there is provided an apparatus comprising:

a first layer of a semiconducting material;
a second layer of a two dimensional material, wherein the first and second layers are configured to form an electrical junction, the electrical junction having a potential energy barrier;
a third layer of a material configured to generate one or more excitons upon absorption of incident electromagnetic radiation;

wherein the apparatus is configured such that said one or more excitons generated in the third layer change the potential energy barrier of the electrical junction.

According to various but not necessarily all examples of the disclosure there is provided an array, module, sensor or photodetector comprising the above apparatuses, or a device comprising the same.

BRIEF DESCRIPTION OF THE DRAWINGS

For a better understanding of various examples of the present disclosure that are useful for understanding the detailed description and certain embodiments of the invention, reference will now be made by way of example only to the accompanying drawings in which:

Figure 1 schematically illustrates an example of an apparatus according to the present disclosure;
Figures 2A and 2B schematically illustrate examples of band diagrams of an apparatus according to the present disclosure with zero bias and a forward bias respectively;
Figure 3 schematically illustrates a graph of theoretical values of diode current vs. forward bias for an apparatus according to the present disclosure;
Figure 4 schematically illustrates a graph of theoretical values of photocurrent vs. forward bias for an apparatus according to the present disclosure;
Figure 5 schematically illustrates a graph of theoretical values of responsivity vs. forward bias for an apparatus according to the present disclosure;
Figure 6 schematically illustrates an example of a further apparatus according to the present disclosure; and
Figure 7 schematically illustrates an example of an array of apparatuses according to the present disclosure.

The Figures are not necessarily to scale. Certain features and views of the figures may be shown schematically or exaggerated in scale in the interest of clarity and conciseness.

DETAILED DESCRIPTION

Examples of an apparatus will now be described with reference to the Figures. Similar reference numerals are used in the Figures to designate similar features. For clarity, all reference numerals are not necessarily displayed in all figures.

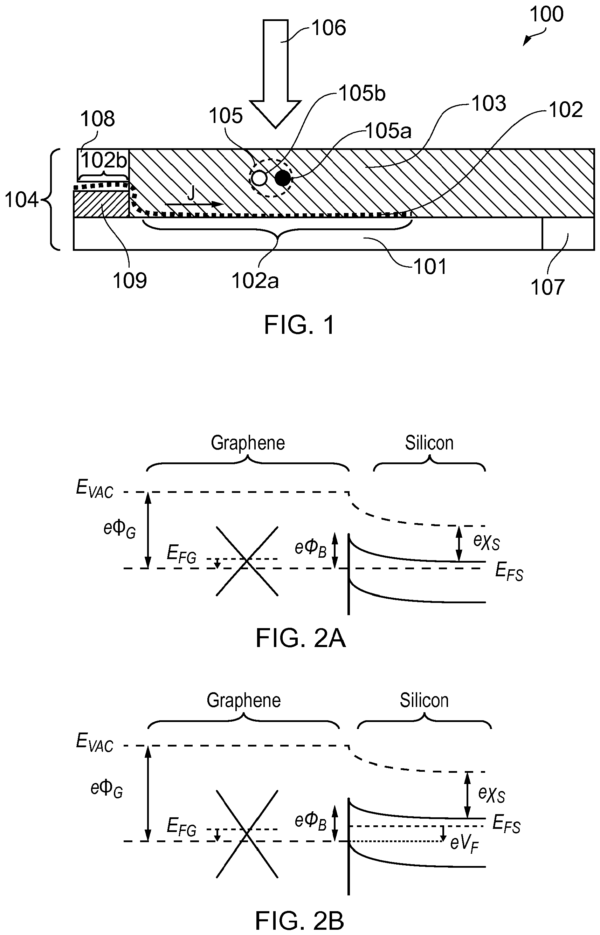

Figure 1 schematically illustrates a cross sectional view of an apparatus 100 comprising:

a first layer of a semiconducting material 101;
a second layer of a two dimensional material 102, wherein the first and second layers are configured to form an electrical junction 104, the electrical junction 104 having a potential energy barrier $\Phi_B$;
a third layer of a material 103 configured to generate one or more excitons 105 upon absorption of incident electromagnetic radiation 106;

wherein the apparatus 100 is configured such that said one or more excitons 105 generated in the third layer 103 change the potential energy barrier $\Phi_B$ of the electrical junction 104.

Figure 1 focuses on the functional components necessary for describing the operation of the apparatus 100.

The first layer of a semiconducting material 101, may, for example, be a layer of silicon or other semiconducting material/means. The second layer of a two dimensional material 102, may for example be a layer of graphene or other conductive two dimensional material, such as a two dimensional material that may be degenerately/excessively doped. The second layer 102 consists of a single layer, e.g. single layer graphene (SLG). In an example not part of the invention the second layer 102 consists of n layers of a two dimensional material, where n is less than or equal to 5. The use of just a single layer or n layers of two dimensional material may reduce the density of states of the material which in turn may increase the sensitivity of the material's Fermi level to external stimuli (such as the photo induced field created in the third layer 103 as discussed below).

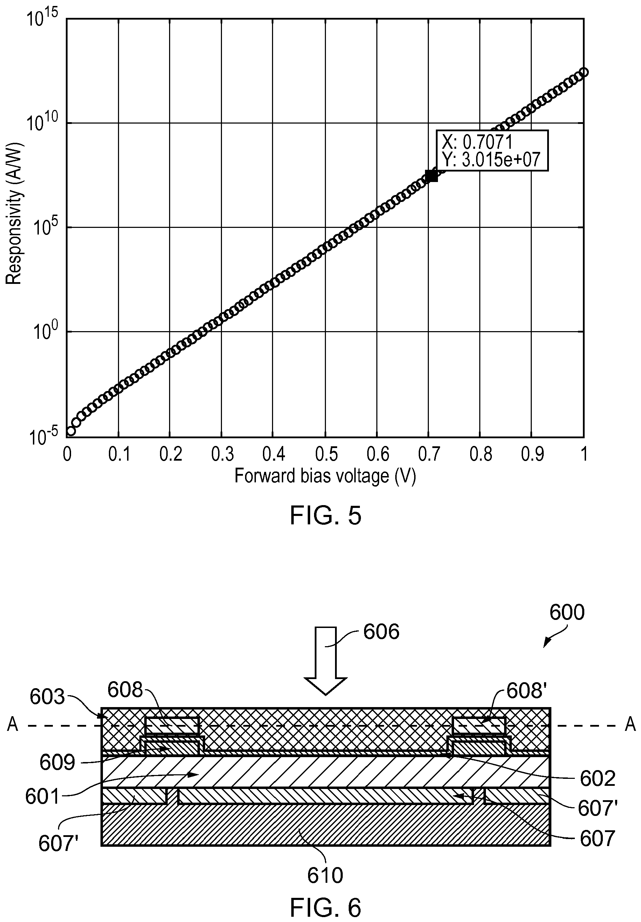

The electrical junction 104 may be one or more of: a rectifying junction, a Schottky junction, and a Schottky diode junction. The potential energy barrier $\Phi_B$ may be a Schottky barrier height. Such a junction may be formed by the provision for a first electrode 107 for the first layer 101 which is in direct and Ohmic contact therewith, and a second separate electrode 108 for the second layer 102 which is in direct and Ohmic contact therewith. A part of the second layer 102a is in direct physical contact with the first layer 101. A part of the second layer 102b, which is in the vicinity of the second electrode 108, is not in direct physical contact with the first layer 101 and instead may be separated therefrom via a spacing element 109, such as a portion of an insulating material e.g. $SiO_2$. It is to be appreciated that the locations / relative arrangement of the first and second electrodes 107 and 108 may differ to that shown in Figure 1 (for example, the first electrode 107 could be disposed beneath the layer of a semiconducting material 101 as in Figure 6 below).

The third layer of material, which is configured to generate one or more excitons 105 upon absorption of one or more incident photons / electromagnetic radiation 106, may for example be one or more of:

formed of a semiconducting material;
formed of a functionalised semiconducting material;
formed of semiconductor nanocrystals;
comprises quantum dots;
comprises colloidal quantum dots.

The third layer of material 103, may be in direct contact with the second layer 102. In some examples the third layer may be an upper/externally facing layer of the apparatus that is exposed to incident electromagnetic radiation.

The apparatus 100 is configured such that one of an electron 105a or an electron hole 105b of an exciton 105 generated in the third layer 103 creates a photo induced field which acts to alter a Fermi level $E_{FG}$ of the two dimensional material of the second layer 102. Such an alteration of the Fermi level $E_{FG}$ alters the potential energy barrier $\Phi_B$ of the electrical junction 104. The altering of the potential energy barrier $\Phi_B$ of the electrical junction 104 affects a current flowing through the electrical junction between the first and second layers 101 and 102, i.e. affect a current J flowing between the first and second electrodes 107 and 108.

In examples of the apparatus, the current J passing through the electrical junction 104 is modulated in dependence upon a level of the potential energy barrier $\Phi_B$ of the electrical junction 104, which itself is dependent upon the number of excitons 105 generated in the third layer 103. The number of excitons generated depends on the flux of electromagnetic radiation 106 incident to the third layer 103. Thus, the current flowing through the electrical junction is dependent upon the flux of electromagnetic radiation incident to the third layer. Accordingly, the apparatus can be used as a photodetector.

By way of an example, in one particular apparatus 100, the first layer 101 is a layer of Silicon and the second layer 102 is single layer graphene (SLG). These two layers are configured so as to form a Schottky diode junction 104, having a Schottky barrier height $\Phi_B$. The third layer 103 is of a semiconductor material duly functionalised to generate excitons 105 upon absorption of electromagnetic radiation 106. Such a material may comprise semiconductor nanocrystals and/or Quantum Dots, such as a Colloidal Quantum Dot (CQD) film configured to generate excitons 105 upon absorption of electromagnetic radiation 106. The semiconductor nanocrystals/CQD layer can be duly configured/functionalised to be responsive to particular frequency/frequencies of electromagnetic radiation.

When illuminated, the third layer generates excitons / electron-hole pairs upon photon absorption. This occurs at a certain quantum efficiency QE, e.g. about 25% for certain PbS QD's. One of the electron 105a or the hole 105b of the exciton 105 may pass from the semiconductor nanocrystals/CQD layer 103 to the graphene layer 102. The remaining charge carrier in the semiconductor nanocrystals/CQD layer (i.e. the other of the electron 105a or hole 105b) may be temporarily "trapped" in the semiconductor nanocrystals/CQD layer due to the layer's relatively poor carrier mobility ($10^{-3}$ to 1 cm$^2$/Vs). The trap lifetime ($\tau_{trap}$) is of the order of 20ms to 1 second.

The exciton formation and subsequent charge separation and charge transfer at the QD-graphene interface may affect the charge density of the graphene layer 102 which may in turn affect the Fermi energy $E_{FG}$ of the graphene. Such a change in the graphene's Fermi energy $E_{FG}$ may itself affect the work function of the graphene $\Phi_G$ which may in turn affect the Schottky barrier height $\Phi_B$ of the Schottky diode junction 104. Such a change in the Schottky barrier height $\Phi_B$ may affect a current flow J through the Schottky diode between the electrodes 107 and 108. The change in current flow J may be detected and measured and used to provide a signal indicative of an amount of light incident to the third layer, such that the apparatus 100 may be used as a sensor/photodetector.

In certain examples of an apparatus according to the present disclosure, light 106 incident to the third layer 103 may cause a modulation of the Schottky barrier height $\Phi_B$ of the Schottky diode junction 104 which may modulate the current flow J through the Schottky diode junction 104. Significantly, since the current flow through a Schottky diode junction is exponentially proportional to the Schottky barrier height $\Phi_B$ (see equation 2 below) examples of the present disclosure may provide highly sensitive sensor for detecting/measuring incident light with high levels of responsivity.

Moreover, examples may enable the use of low operational current levels, thereby reducing power consumption levels. Such reduced power consumption levels may be particularly advantageous when large numbers (> millions) of the apparatuses are configured together and scaled up to form pixels of a photodetector array.

Conventional Schottky junction diodes (based on a metal - semiconductor junction) are not sensitive to external stimuli as the metal has such a large charge carrier density there is no modulation of its Fermi energy upon application of an external field. Moreover, the semiconductor layer of a conventional Schottky junction diode is likewise too thick for any external stimulus to be able to modulate the band structure of a conventional Schottky barrier interface. By contrast, in examples of the present disclosure a two dimensional material (instead of a metal) is used that has a lower density of states as compared to a metal. The use of such a material enables the Fermi level of the two dimensional material to be sensitive to external stimuli, e.g. a photo induced field from the third layer, such that such a photo induced field may modulate the band structure of the Schottky barrier interface of examples of the present disclosure.

Figures 2A and 2B schematically illustrate examples of band diagrams for an apparatus according to the present disclosure with zero bias and a forward bias $V_F$ respectively. The apparatus is similar to that set out above with regards to Figure 1, wherein the material of the first layer 101 is Silicon, the 2 dimensional material of the second layer 102 is graphene, the electrical junction is a Schottky diode junction, and the potential barrier is a Schottky barrier height $\Phi_B$.

These figures show the Schottky barrier height $\Phi_B$ equals the work function $\Phi_G$ of the graphene - the electron affinity $\chi_S$ of the Silicon, i.e.:

$$\phi_B = \Phi_G - \chi_s$$

$E_{FG}$ is the difference of the graphene's Fermi energy relative to the charge neutrality point, Dirac point (likewise, $E_{FS}$ relates to the Silicon's Fermi energy level). The change in Fermi energy in the graphene, relative to the charge neutrality point, can be calculated as:

$$E_{FG} = -\hbar v_F \sqrt{\pi n}.$$

where:

$v_F$ is the Fermi velocity of graphene
n is the charge density in the graphene

Hence graphene's Fermi energy $E_{FG}$ will change as a function of a change in the graphene's charge density, n.

The charge density in the graphene, n, equals:

$$n = n_0 + n_a$$

where:

$$n_0 = n_r - n_{induced}$$

$n_a$ is the carrier density after addition of a p-type dopant (i.e. due to the QD layer 103)

$n_r$ is the residual doping of graphene before it makes contact with the semiconductor (i.e. in the region 102b)

$n_{induced}$ is the charge density induced in the graphene when contacting Silicon (i.e. in the region 102a) to form Schottky barrier

The classic Schottky-Mott model states that any semiconductor with electron affinity ($\chi_s$) smaller than the work function of the metal ($\Phi_M$) can create a rectifying junction with barrier height $\phi_B = \Phi_M - \chi_s$. In the case, graphene is used instead of a metal. Also, the Fermi level for graphene is not fixed, so the graphene's work function $\Phi_G$ can vary. The change in graphene's work function $\Phi_G$ which is due to the change in carrier density due to the excitons greated in the QD layer 103, can be expressed as:

$$e\Delta\Phi_G = -\Delta E_{FG} = e\hbar v_F\left(\sqrt{\pi(n_0 + n_a)} - \sqrt{\pi n_0}\right)$$

If the Schottky barrier height before addition of dopant is labled as $\phi_{B0} = \Phi_G - \chi_s$ then the Schottky barrier height after addition of a dopant (ie. due to the excitons greated in the QD layer 103) becomes:

$$\phi_B = \phi_{B0} + \Delta\Phi_G$$

$$\phi_B = \phi_{B0} + \hbar v_F\left(\sqrt{\pi(n_0 + n_a)} - \sqrt{\pi n_0}\right) \qquad \text{(Equation 1)}$$

In a Schottky junction diode, the net forward current flow J may be represented as:

$$J = A^* T^2 \exp\left(-\frac{e\phi_B}{kT}\right)\left[\exp\left(\frac{eV}{kT}\right) - 1\right] \qquad \text{(Equation 2)}$$

where:

$J$ is the current density
$A^*$ is the Richardson constant
$T$ is the absolute temperature
$e$ is the elementary charge
$\phi_B$ is the Schottky barrier height
$k$ is Boltzmann constant
$V$ is the applied voltage across the junction (i.e. between the first and second electrodes 107 and 108).

Thus, from equation 1, it can be seen that the Schottky barrier height $\Phi_B$ is proportional to the carrier density $n_a$ after addition of a p-type dopant (i.e. due to the QD layer 103). From equation 2, it can be seen that the current density, J, is exponentially proportional to the Schottky barrier height $\Phi_B$. Thus, a minor change in the carrier density $n_a$ due to the creations of excitons in the QD layer 103 upon illumination may give rise to a significant change in the current density.

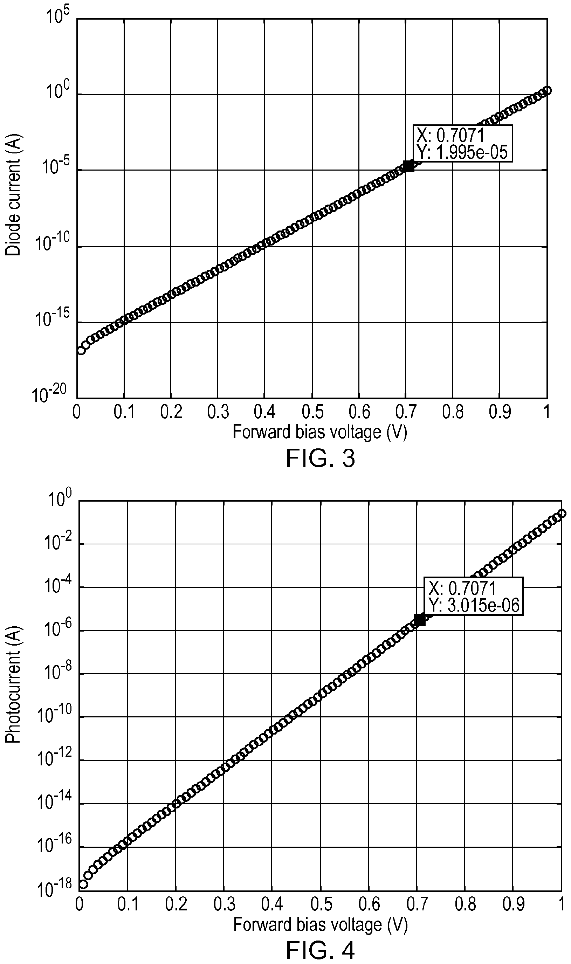

Figure 3 schematically illustrates a graph of theoretical values of diode current, i.e. J, vs. forward bias voltage applied to the apparatus.

The values for the graph are derived from Equations 1 and 2 along with the following values: sensor/detection area

$$A = 250 \times 10^{-8} \text{cm}^{-2} \text{ i.e. } 50\mu\text{m} \times 50\mu\text{m pixels}$$

Richardson constant

$$A^* = 1.2 \times 10^2 \text{Acm}^{-2}\text{K}^{-2}$$

$$T = 300 \text{ K}, \; e = 1.6 \times 10^{-19}\text{C},$$

$$k = 1.38 \times 10^{-23}\text{m}^2\text{kgs}^{-2}\text{K}^{-1}$$

$$\Phi_{G,Dirac} = 4.9 \text{ eV},$$

$$\chi_s = 4.05 \text{ eV for Si}$$

$$\hbar = 6.5 \times 10^{-16}\text{eV.s},$$

$$v_F = 1.1 \times 10^8 \text{cm s}^{-1}$$

$$n_r = 5 \times 10^{12} \text{cm}^{-2},$$

$$n_{induced} = 5 \times 10^{10} \text{cm}^{-2}$$

An illumination power of 0.1pW incident on the sensor/detection area may be equivalent to $6 \times 10^{11}$ photons/cm$^2$/s. Assuming a quantum efficiency QE of 25%, yields $1.5 \times 10^{11}$ excitons generated per cm$^2$ in 1 second.

Figure 3 is a plot of the theoretical current at such an incident power level for the above described Schottky junction diode with a forward bias, V.

Figure 4 schematically illustrates a graph of theoretical values of photocurrent vs. forward bias for the above described Schottky junction diode.

Figure 5 schematically illustrates a graph of theoretical values of responsivity vs. forward bias for the above described Schottky junction diode.

Figures 3 - 5 reveal that operating the above described Schottky junction diode at a bias voltage of 0.7 V yields an operating current of 20 $\mu$A, a photocurrent of 3 $\mu$A for an incident optical power of 0.1pW, and a responsivity of $3 \times 10^7$A/W. Such responsivity is comparable to that of a hybrid QD-GFET (quantum dot graphene field effect transistor) photodetector. However, whereas an operating current /current drain of an exemplary GFET may be ca. 1mA (irrespective of whether if GFET is in an illuminated or dark state), the operating current of above described Schottky junction diode is ca. 20 $\mu$A, i.e. several orders of magnitude less. Advantageously, examples of the present disclosure may provide a photodetector having a low operating current, thereby enabling significant reductions in power consumption, i.e. as compared to other types of photodetectors such as GFET based photodetectors. Such power reductions may be particularly advantageous where the apparatuses are combined into large arrays comprising millions of individual apparatuses/detectors. Moreover, a low operational current can lessen issues that might otherwise be faced for high operational current with regards to interfacing electronics.

The above described example considers a Schottky junction diode configured for a forward bias mode of operation. In other examples, the Schottky junction diode may be configured to be operated in reverse bias. This may result in an even lower operating current.

Figure 6 schematically illustrates an example of a further apparatus 600 according to the present disclosure. The apparatus 600 comprises a first layer 601 comprising a semiconductor, such as Silicon. A second layer of graphene 602 is provided in direct contact with the semiconductor layer and forms a Schottky junction with the semiconductor. A plurality of electrodes 607, 607' are provided that are in ohmic electrical contact with the first semiconductor layer 601 respectively. A further plurality of electrodes 608, 608' are provided that are in ohmic electrical contact with the graphene layer 602. Regions of the graphene layer 602 that are in ohmic contact with the electrodes 608, 608' are not in direct contact with the semiconductor layer 601. An insulator 609 is provided between the graphene layer and the semiconductor layer in the regions in the vicinity of the electrodes 608, 608'.

The electrodes 607, 607', 608, 608' are configured and controlled such that a potential difference V can be applied between the graphene and the Semiconductor layers 601, 602 and such that a current flow J to/from the graphene and semiconductor layers can be measured.

Figure 6 illustrates a partial cross-section section of the apparatus 600 which shows part of an arrangement of layers and electrodes which is repeated in the longitudinal direction. The central region of the figure represents a single pixel of the apparatus. It is to be appreciated that the arrangement repeats such that the left hand region of the apparatus (i.e. commencing from the gap between the first two electrodes 607' and 607) corresponds to a part of an adjacent pixel. Likewise, the right hand region of the apparatus (i.e. commencing from the gap between the second and third electrodes 607 and 607') corresponds to a part of another adjacent pixel.

Each pixel of the apparatus may be provided with a unique electrode / electrical contact 607 for the semiconductor layer 601. The electrode 607 may define a pixel area of the apparatus 600.

A base substrate 610 is provided on which the various layers are themselves provided. It is to be appreciated that additional circuitry may be provided (e.g. a backplane not shown) for selecting/addressing particular electrodes to enable the selective addressing of a particular pixel and a readout of current therefrom.

A third layer 603 of appropriately-functionalised semiconductor nanocrystals is provided that overlays and is in direct contact with the graphene layer 602. The semiconductor nanocrystals are configured so as to absorb incoming light and generate excitons. Depending on the band alignment between the semiconductor nanocrystals 603 and the graphene 602, either a hole or an electron from an exciton is passed to the graphene. The remaining charge in the semiconductor nanocrystals layer 603 acts, in effect, to electrostatically gate the graphene layer by altering the Fermi energy $E_{FG}$ of the graphene and consequently the Schottky barrier height $\Phi_B$ and also thereby altering a current J between the graphene and the semiconductor layers 602, 601.

It will be appreciated that the apparatuses 100 and 600 of the present disclosure can be driven by an alternating current (AC) in which case the apparatuses would provide a rectified output voltage proportional to the illumination level (and the number of excitons created in the third layer 103, 603). This can allow the apparatuses to be wirelessly powered for example by inductive coupling if the apparatuses were coupled to an inductor loop or other kind of antenna.

In one embodiment, the apparatuses or an array of apparatuses can be embodied in a medical imaging device. For example, an array of apparatuses can be integrated with an X-ray scintillator to form part of an X-ray imaging device.

The above described apparatuses 100 and 600 may be provided in a module. As used here 'module' refers to a unit or apparatus that excludes certain parts/components that would be added by an end manufacturer or a user.

The above described apparatuses and modules may be provided as a sensor or photodetector and may be combined together to form arrays of the same.

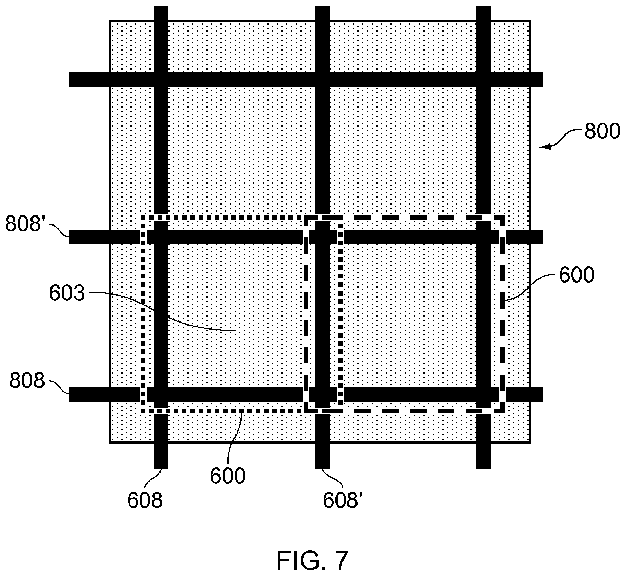

Figure 7 schematically illustrates an example of an array 800 of a plurality of apparatuses 600. Each apparatus 600 may form a pixel of the array. The Figure illustrates the array from a plan view perspective and moreover relates to a plan view cut through view of the apparatus 600 of Figure 6 along the line A-A.

In the array, the (second) electrode/electrical contact for the (second) graphene layer for each pixel 600 may be shared and common with one another across the array. I.e. each of the electrodes for the graphene layer, 608, 608', 808, 808' are all in contact with one another, for instance the column graphene electrodes 608 and 608' interconnect with and are in contact with the row graphene electrodes 808 and 808'.

A unique (first) electrode 607 for the (first) silicon layer (not shown) is provided for each pixel 600 of the array. The electrode 607 (not shown) is configured to define the pixel area and is arranged beneath the central region of each pixel and extends across the area of the central region (i.e. in this case a square shaped electrode for the silicon layer is provided for each pixel) thereby defining effective pixel area, i.e. the photo responsive/detecting area which may correspond to the area of third layer of semiconductor nanocrystals disposed above the first electrode.

Such an arrangement may increase the fill factor of the pixel, i.e. reduce the coverage area of the electrodes (and the "shadowing effect" they have reducing the pixel's effective photosensitive area surface). This may increase the surface area of the (third) layer of semiconductor nanocrystals available to receive incident light and thus increase the active photosensitive area surface area of each pixel and the array.

The array 800 may further include means configured to selectively address one or more of the pixels and read an output therefrom, e.g. an active matrix backplane / addressing and readout circuitry (not shown).

Although examples of the apparatus have been described above in terms of comprising various components, it should be understood that the components may be embodied as or otherwise controlled by a corresponding controller or circuitry such as one or more processing elements or processors of the apparatus. In this regard, each of the components described above may be one or more of any device, means or circuitry embodied in hardware, software or a combination of hardware and software that is configured to perform the corresponding functions of the respective components as described above. For example, a backplane may be provided with circuitry configured to: selectively address particular electrodes, apply a voltage to particular electrodes, and to read out/measure a current from particular electrodes.

It will be appreciated that the above described apparatuses, modules, sensors, photodetectors and arrays may be provided/ embodied in a device, which may provide functionality other than sensing/photo detection.

For example, the device may be a hand held portable electronic device, such as a mobile telephone, wearable computing device or personal digital assistant, that may additionally provide one or more audio/text/video communication functions (e.g. tele-communication, video-communication, and/or text transmission (Short Message Service (SMS)/ Multimedia Message Service (MMS)/emailing) functions), interactive/non-interactive viewing functions (e.g. web-browsing, navigation, TV/program viewing functions), music recording/playing functions (e.g. Moving Picture Experts Group-1 Audio Layer 3 (MP3) or other format and/or (frequency modulation/amplitude modulation) radio broadcast recording/playing), downloading/sending of data functions, image capture function (e.g. using a (e.g. in-built) digital camera), and gaming functions.

The apparatus may be provided in an electronic device, for example, a mobile terminal, according to an exemplary embodiment of the present disclosure. It should be understood, however, that a mobile terminal is merely illustrative of an electronic device that would benefit from examples of implementations of the present disclosure and, therefore, should not be taken to limit the scope of the present disclosure to the same. While certain in certain implementation examples the apparatus may be provided in a mobile terminal, other types of electronic devices, such as, but not limited to, hand portable electronic devices, wearable computing devices, personal digital assistants (PDAs), pagers, mobile computers, desktop computers, televisions, gaming devices, laptop computers, tablets, cameras, video recorders, GPS devices and other types of electronic systems, may readily employ examples of the present disclosure. Furthermore, devices may readily employ examples of the present disclosure regardless of their intent to provide mobility.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to "comprising only one ..." or by using "consisting".

In this description, reference has been made to various examples. The description of features or functions in relation to an example indicates that those features or functions are present in that example. The use of the term 'example' or 'for example' or 'may' in the text denotes, whether explicitly stated or not, that such features or functions are present in at least the described example, whether described as an example or not, and that they can be, but are not necessarily, present in some or all other examples. Thus 'example', 'for example' or 'may' refers to a particular instance in a class of examples. A property of the instance can be a property of only that instance or a property of the class or a property of a sub-class of the class that includes some but not all of the instances in the class.

In this description, references to "a/an/the" [feature, element, component, means ...] are to be interpreted as "at least one" [feature, element, component, means ...] unless explicitly stated otherwise.

**Claims**

1.  An apparatus (100) comprising:

    a first layer of a semiconducting material (101);
    a first electrode (107) for the first layer;
    a second layer of a two dimensional material (102), wherein the second layer of the two dimensional material consists of substantially a single layer of two dimensional material;
    a second electrode (108) for the second layer;
    wherein the first and second layers are configured to form an electrical junction (104), wherein the electrical junction is configured to enable, in use, a flow of current between the first and second electrodes through the first and second layers, and wherein the electrical junction has a potential energy barrier;
    a third layer of a material (103) configured to generate, in use, one or more excitons (105) upon absorption of incident electromagnetic radiation (106) wherein, in use, said one or more excitons generated in the third layer creates a photo induced field which acts to alter a Fermi Level of the second layer that changes the potential energy barrier of the electrical junction thereby affecting the flow of current through the electrical junction between the first and second electrodes.

2.  The apparatus of claim 1, wherein the electrical junction is one or more of: a rectifying junction, a Schottky junction, and a Schottky diode junction.

3.  The apparatus of any one or more of the previous claims, wherein the potential energy barrier is a Schottky barrier height.

4. The apparatus of any one or more of the previous claims, wherein the two dimensional material is graphene.

5. The apparatus of any one or more of the previous claims, wherein the apparatus is configured such that one of an electron (105a) or an electron hole (105b) of an exciton generated in the third layer acts to alter a Fermi level of the two dimensional material of the second layer thereby altering the potential energy barrier of the electrical junction.

6. The apparatus of any one or more of the previous claims, wherein the apparatus is configured such that, in use, a current passing through the electrical junction is modulated in dependence upon a level of the potential energy barrier.

7. The apparatus of any one or more of the previous claims, wherein the material of the third layer is one or more of:

   formed of a semiconducting material;
   formed of a functionalised semiconducting material;
   formed of semiconductor nanocrystals;
   comprises quantum dots;
   comprises colloidal quantum dots.

8. A system comprising an array of a plurality of apparatuses of any one or more of claims 1 - 7.

9. The system of claim 8, wherein each of the second electrodes of the plurality of apparatuses is shared across the array.

10. The system of claim 9, wherein each of the plurality of apparatuses defines a pixel for the array; and wherein the first electrode of each pixel is unique for each pixel of the array; and preferably wherein each of the first electrodes defines each pixel area.

11. A photodetector, sensor or module comprising the apparatus as claimed in any one or more of claims 1 - 7, or the system of any one or more of claims 8-10.

12. A device comprising:

   the apparatus of any one or more of claims 1 - 7;
   the system of any one or more of claims 8- 10; and/or
   the photodetector, sensor or module of claim 11.

**Patentansprüche**

1. Vorrichtung (100), die umfasst:

   eine erste Schicht aus einem Halbleitermaterial (101);
   eine erste Elektrode (107) für die erste Schicht;
   eine zweite Schicht aus einem zweidimensionalen Material (102), wobei die zweite Schicht aus dem zweidimensionalen Material aus im Wesentlichen einer einzigen Schicht aus zweidimensionalem Material besteht;
   eine zweite Elektrode (108) für die zweite Schicht;
   wobei die erste und die zweite Schicht dazu ausgestaltet sind, einen elektrischen Übergang (104) zu bilden, wobei der elektrische Übergang dazu ausgestaltet ist, bei der Verwendung einen Fluss von Strom zwischen der ersten und der zweiten Elektrode durch die erste und die zweite Schicht zu ermöglichen, und wobei der elektrische Übergang eine Potentialenergiebarriere aufweist;
   eine dritte Schicht aus einem Material (103), die dazu ausgestaltet ist, bei der Verwendung bei der Absorption von einfallender elektromagnetischer Strahlung (106) ein oder mehrere Exzitonen (105) zu erzeugen, wobei das eine oder die mehreren Exzitonen, die in der dritten Schicht erzeugt werden, ein lichtinduziertes Feld erzeugen, das wirkt, um ein Fermi-Niveau der zweiten Schicht zu ändern, das die Potenzialenergiebarriere des elektrischen Übergangs ändert und dabei den Fluss von Strom durch den elektrischen Übergang zwischen der ersten und der zweiten Elektrode beeinflusst.

2. Vorrichtung nach Anspruch 1, wobei der elektrische Übergang eines oder mehrere von Folgendem ist: ein gleichrichtender Übergang, ein Schottky-Übergang und ein Schottky-Dioden-Übergang.

3. Vorrichtung nach einem oder mehreren der vorhergehenden Ansprüche, wobei die Potentialenergiebarriere eine Schottky-Barrierenhöhe ist.

4. Vorrichtung nach einem oder mehreren der vorhergehenden Ansprüche, wobei das zweidimensionale Material Graphen ist.

5. Vorrichtung nach einem oder mehreren der vorhergehenden Ansprüche, wobei die Vorrichtung derart ausgestaltet ist, dass eines von einem Elektron (105a) oder einem Elektronloch (105b) eines Exzitons, das in der dritten Schicht erzeugt wird, wirkt, um ein Fermi-Niveau des zweidimensionalen Materials der zweiten Schicht zu ändern, wodurch die Potentialenergiebarriere des elektrischen Übergangs geändert wird.

6. Vorrichtung nach einem oder mehreren der vorhergehenden Ansprüche, wobei die Vorrichtung derart ausgestaltet ist, dass bei der Verwendung ein Strom, der den elektrischen Übergang durchquert, in Abhängigkeit von einem Niveau der Potentialenergiebarriere moduliert wird.

7. Vorrichtung nach einem oder mehreren der vorhergehenden Ansprüche, wobei das Material der dritten Schicht eines oder mehrere von Folgendem ist:

gebildet aus einem Halbleitermaterial;
gebildet aus einem funktionalisierten Halbleitermaterial;
gebildet aus Halbleiter-Nanokristallen;
Quantenpunkte umfasst;
kolloidale Quantenpunkte umfasst.

8. System, das eine Anordnung einer Vielzahl von Vorrichtungen nach einem oder mehreren der Ansprüche 1 bis 7 umfasst.

9. System nach Anspruch 8, wobei jede der zweiten Elektroden von der Vielzahl von Vorrichtungen über die Anordnung hinweg gemeinsam genutzt wird.

10. System nach Anspruch 9, wobei jede von der Vielzahl von Vorrichtungen ein Pixel für die Anordnung definiert; und wobei die erste Elektrode von jedem Pixel für jedes Pixel der Anordnung eindeutig ist; und wobei vorzugsweise jede der ersten Elektroden jeden Pixelbereich definiert.

11. Photodetektor, Sensor oder Modul, das die Vorrichtung nach einem der Ansprüche 1 bis 7 oder das System nach einem oder mehreren der Ansprüche 8 bis 10 umfasst.

12. Bauelement, das umfasst:

die Vorrichtung nach einem oder mehreren der Ansprüche 1 bis 7;
das System nach einem oder mehreren der Ansprüche 8 bis 10; und/oder
den Photodetektor, den Sensor oder das Modul nach Anspruch 11.

**Revendications**

1. Appareil (100) comprenant :

une première couche en un matériau semi-conducteur (101) ;
une première électrode (107) pour la première couche ;
une deuxième couche en un matériau bidimensionnel (102), dans laquelle la deuxième couche en le matériau bidimensionnel est constituée sensiblement en une seule couche de matériau bidimensionnel ;
une deuxième électrode (108) pour la deuxième couche ;
dans lequel les première et deuxième couches sont configurées pour former une jonction électrique (104), dans lequel la jonction électrique est configurée pour permettre, lors de l'utilisation, une circulation de courant entre les première et deuxième électrodes à travers les première et deuxième couches, et dans lequel la jonction électrique a une barrière d'énergie potentielle ;

une troisième couche en un matériau (103) configuré pour générer, lors de l'utilisation, un ou plusieurs excitons (105) suite à l'absorption d'un rayonnement électromagnétique incident (106), dans lequel, lors de l'utilisation, lesdits un ou plusieurs excitons générés dans la troisième couche créent un champ photo-induit qui agit de manière à altérer le niveau de Fermi de la deuxième couche qui change la barrière d'énergie potentielle de la jonction électrique en affectant ainsi la circulation de courant à travers la jonction électrique entre les première et deuxième électrodes.

2. Appareil selon la revendication 1, dans lequel la jonction électrique est un ou plusieurs parmi : une jonction de redressement, une jonction Schottky, et une jonction de diode à effet Schottky.

3. Appareil selon l'une quelconque ou plusieurs des revendications précédentes, dans lequel la barrière d'énergie potentielle est une hauteur de barrière à effet Schottky.

4. Appareil selon l'une quelconque ou plusieurs des revendications précédentes, dans lequel le matériau bidimensionnel est un graphène.

5. Appareil selon l'une quelconque ou plusieurs des revendications précédentes, dans lequel l'appareil est configuré de façon que l'un parmi un électron (105a) ou un trou d'électron (105b) d'un exciton généré par la troisième couche agisse de manière à altérer le niveau de Fermi du matériau bidimensionnel de la deuxième couche en altérant ainsi la barrière d'énergie potentielle de la jonction électrique.

6. Appareil selon l'une quelconque ou plusieurs des revendications précédentes, dans lequel l'appareil est configuré de façon que, lors de l'utilisation, un courant traversant la jonction électrique soit modulé en fonction du niveau de la barrière d'énergie potentielle.

7. Appareil selon l'une quelconque ou plusieurs des revendications précédentes, dans lequel le matériau de la troisième couche est un ou plusieurs parmi :

   formé d'un matériau semi-conducteur ;
   formé d'un matériau semi-conducteur fonctionnalisé ;
   formé de nanocristaux semi-conducteurs ;
   comprend des boîtes quantiques ;
   comprend des boîtes quantiques colloïdales.

8. Système comprenant un réseau d'une pluralité d'appareils selon l'une quelconque ou plusieurs des revendications 1 à 7.

9. Système selon la revendication 8, dans lequel chacune des deuxièmes électrodes de la pluralité d'appareils est partagée sur le réseau.

10. Système selon la revendication 9, dans lequel chacun parmi la pluralité d'appareils définit un pixel pour le réseau ; et dans lequel la première électrode de chaque pixel est unique pour chaque pixel du réseau ; et de préférence dans lequel chacune des premières électrodes définit chaque superficie de pixel.

11. Photodétecteur, capteur ou module comprenant l'appareil tel que défini dans l'une quelconque ou plusieurs des revendications 1 à 7, ou le système selon l'une quelconque ou plusieurs des revendications 8 à 10.

12. Dispositif comprenant :

   l'appareil selon l'une quelconque ou plusieurs des revendications 1 à 7 ;
   le système selon l'une quelconque ou plusieurs des revendications 8 à 10 ; et/ou
   le photodétecteur, capteur ou module selon la revendication 11.

FIG. 1

FIG. 2A

FIG. 2B

FIG. 3

FIG. 4

FIG. 5

FIG. 6

FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **MIAO ZHU et al.** TiO2 enhanced ultraviolet detection based on a graphene/Si Schottky diode. *Journal of Materials Chemistry A,* January 2015, vol. 3 (15), 8133-8138